Europäisches Patentamt

European Patent Office

Office européen des brevets

(19)

(11) Publication number: **0 310 265**

A1

## EUROPEAN PATENT APPLICATION

(12)

(21) Application number: **88308550.8**

(22) Date of filing: **15.09.88**

(51) Int. Cl.⁴: **C30B 29/62 , D01F 9/08 , C01B 31/36**

(30) Priority: **30.09.87 US 103100**

(43) Date of publication of application:
**05.04.89 Bulletin 89/14**

(84) Designated Contracting States:
**DE FR GB NL**

(71) Applicant: **THE STANDARD OIL COMPANY**
**200 Public Square, 36-F-3454**
**Cleveland Ohio 44114-2375(US)**

(72) Inventor: **Biernacki, Joseph J.**
**1926 W. Schaaf Road**
**Cleveland Ohio 44109(US)**
Inventor: **Fox, Joseph R.**
**35906 Meadowdale Drive Avenue**
**Solon Ohio 44139(US)**
Inventor: **Bodolus, Christopher L.**
**3820 Lowell Road**
**Cleveland Heights Ohio 44139(US)**
Inventor: **White, Douglas A.**
**1007 Quilliams Road**
**Cleveland Heights Ohio 44121(US)**

(74) Representative: **Ryan, Edward Terrence et al**
**BP INTERNATIONAL LIMITED, Patents**
**Division Chertsey Road**
**Sunbury-on-Thames Middlesex, TW16**
**7LN(GB)**

(54) Formation of fibrous silicon carbide and silicon nitride.

(57) A method of forming fibrous silicon carbide and silicon nitride comprising the steps of mixing a silicon source and microfibrous carbon to form a silicon-carbon mixture, and thereafter heating the silicon-carbon mixture to a temperature of at least 1300°C in the presence of a non-oxidizing gas or under vacuum. The microfibrous carbon containing at least one transition metal, such as: Fe, Co, Ni, Ru, Rh, Re, Os, Mn, Cr, V, Ti, Cu, W, Pt, Pd, Mo and Au. It is preferred that the gas be one selected from the group consisting of $H_2$, $N_2$, Ar, He and mixtures thereof. This method produces fibrous silicon carbide with a morphology similar to the starting carbon, thus reducing the yield of undesirable particulate products. The presence of the transition metal in the microfibrous carbon also enhances the formation of fibrous silicon carbide and silicon nitride.

# FORMATION OF FIBROUS SILICON CARBIDE AND SILICON NITRIDE

## BACKGROUND OF THE INVENTION

The invention relates to methods for forming whiskers and fibers of silicon carbide and/or silicon nitride in which a microfibrous carbon is reacted with a suitable silicon source, i.e., $SiO_2$, Si metal, $SiH_4$ or $Si_2H_6$, under conditions conducive to the formation of silicon carbide (SiC) and/or silicon nitride ($Si_3N_4$). Typically, the microfibrous carbon is reacted with a silicon source at temperatures above 1300°C and in the presence of a gas or under vacuum. Microfibrous carbon, particularly carbon deposited during a prior operating step onto a transition metal is used, wherein the transition metal may subsequently act as a catalyst in the formation of whiskers and fibers of silicon carbide and/or silicon nitride. In the inventive process, a significant fraction of the microfibrous carbon can also be converted into microfibrous ceramic which is more oxidation resistant and chemically resistant than the carbon itself. Thus, the yield of fibrous ceramic product is enhanced by the fibrous morphology of the carbon as well as the presence of the metal catalyst.

Growing interest by industry in the area of structural materials having high temperature stability, strength and toughness has caused scientists and engineers to focus on producing such materials. One area which has produced materials with desirable properties and which holds vast potential is that of whisker and fiber reinforced composites, wherein the matrix material is a metal, a glass or a ceramic. Although graphite and carbon fibers have been produced and used to fabricate carbon-carbon composites, their poor oxidation resistance at temperatures above 500°C and reactivity towards molten metals has limited their usefulness in high temperature composites.

The interest in high performance composite materials with improved stability for use in the aeronautic, automobile and chemical industries has led to increased efforts to produce ceramic fibers and whiskers which could be used for such reinforcement purposes. Silicon carbide whiskers and fibers are of particular interest because of their potentially high strength as well as temperature stability and chemical inertness in various environments. Continuous fibers of stoichiometric SiC with diameters in the 1-10 micron range, however, are costly and difficult to manufacture by currently known processing techniques. Composite manufacturers have therefore turned to ceramic whiskers, with diameters typically less than 1 micron, to successfully fabricate both metal-matrix and ceramic-matrix composites. SiC whiskers have been shown to be excellent reinforcements in both alumina and aluminium matrix composites.

The formation of filamentous carbon via the transition metal-catalyzed disproportionation of carbon monoxide or the transition metal-catalyzed decomposition of gaseous hydrocarbons is well documented in the literature (See Great Britain Patent Application No. 2,002,726). The filaments can be formed under mild conditions and offer an exceptional degree of crystallization. Diameters of the filaments can be as high as 0.5 micron, close to that of the aforementioned ceramic whiskers, but are usually lower, i.e., less than 0.1 micron. While these filaments themselves may make excellent reinforcements, they possess the low oxidation resistance and high reactivity towards molten metals characteristic of graphite fibers. These problems can in fact be amplified due to the small size and higher surface area of the filamentous carbon.

From a composites' standpoint, the cost of the reinforcement is a key issue, and it would be desirable to use the filamentous carbon above because the filaments can be formed at relatively low temperatures from relatively inexpensive gases.

Carbon monoxide, for example, is a very desirable feedstock for producing the filamentous carbon, because it can readily be deposited at temperatures of 400-800°C and can be utilized from low value waste streams. Furthermore, carbon monoxide would be a desirable feedstock for producing ceramic materials, because it itself is often a byproduct of the high temperature carbothermic reduction reactions used to produce ceramics and it requires costly emission control. Although it can readily be prepared from carbon monoxide, the usefulness of microfibrous carbon as a reinforcement medium in fabricating ceramic-matrix and metal-matrix composites would be increased significantly if the carbon could be converted into a ceramic material with a fibrous morphology, increased oxidation resistance and lower reactivity towards molten metals.

In the present invention, microfibrous carbon produced from carbon monoxide has been used to prepare a variety of fibrous ceramic products which are useful as high temperature reinforcement materials. The microfibrous nature of the carbon as well as the presence of the transition metal used to catalyze carbon deposition result in enhanced yields of fibrous rather than particulate ceramic products. The present invention is particularly useful for the preparation of fibrous silicon carbide ceramic products.

Silicon carbide is a refractory material having desirable thermal, chemical, electrical, and physical properties and thus it finds many diverse applications including: high-temperature automotive environments, wear-resistant applications, semiconductor processing, and composite materials. The classical reaction between silica ($SiO_2$) and carbon (C) has been used for many years to produce silicon carbide according to the stoichiometric reaction below.

$$SiO_2 + 3C \rightarrow SiC + 2CO \quad (1)$$

The Acheson process is one example of the classical pathway to forming crystalline silicon carbide products, however, they are non-fibrous. Typically, silica-sand and petroleum coke or coal are ground, mixed and reacted at temperatures above 1400°C to form silicon carbide. There are two dominant polytypes of silicon carbide, the beta (cubic) form and the alpha (hexagonal) form. The beta form is favored at low temperatures while the alpha is favored at high temperatures.

In recent years researchers have shown that the presence of various transition metals catalyze the formation of silicon carbide fibers and whiskers. Much of the art deals with the growth of macroscopic whiskers with diameters in the 1-10 micron range on substrates, wherein the reactants are provided via the vapor phase. It is believed that the formation of silicon carbide whiskers according to those processes can be attributed to the catalyzed reaction between vapor phase species. The mechanism believed to account for the growth of such whiskers is generally referred to as the VLS (vapor liquid solid) process. See Wagner, R.S., and Ellis, W.C., Trans. Met. Soc. AIME, Volume 233, pp 1053-1064, (June 1965). In the VLS process, the reactants in the vapor phase react at the catalytic site which is a liquid, to form a solid product.

The VLS process produces silicon carbide by passing gaseous SiO and methane over a molten iron catalyst supported on a carbon substrate. This results in the production of fibers typically having a diameter of approximately 7-10 microns and a length of several inches. At present, however, the VLS process is a relatively low yield method for preparing silicon carbide fiber and is an extremely expensive method for producing large quantities of fibers primarily due to the large quantities of gas which must be utilized and the low specific yield of fibers based on substrate surface area.

Numerous patents have shown that the presence of various elements including Fe, Ni, V, Cr, Pt, Pd, Co, Mo, W, Au, Ti, and La catalyze the formation of silicon carbide whiskers with diameters less than 1 micron when $SiO_2$ or Si are reacted with carbon in granular form. The use of transition metals as catalysts in the formation of silicon carbide is well described in the following : U.S. Patent No. 4,013,503, U.S. Patent No. 3,692,478, U.S.

Patent No. 3,840,647, U.S. Patent No. 3,778,296, U.S. Patent No. 4,500,504, U.S. Patent No. 3,519,472 and U.S. Patent No. 3,773,899. Much of the catalyzed growth of silicon carbide whiskers formed via bulk reaction of Si or $SiO_2$ with carbon is thought to be via the same VLS process described above wherein the transition metal or other liquid phase has actually produced the whisker or fiber monphology. Indeed fibers or whiskers formed via a VLS mechanism can be easily recognized by the presence of a metallic sphere attached to one end of the straight, cylindrical fiber or whisker. A problem with the process described above is that the use of a carbon source with a particulate morphology, i.e., activated carbon, charcoal, or carbon black, typically results in the formation of a significant amount of particulate silicon carbide product which must be separated from the whiskers before they can be used to fabricate composites.

The formation of silicon carbide whiskers from rice hulls has been conducted by heating rice hulls in the absence of oxygen to a temperature within the range of about 1000°C to 2000°C by a reaction between silica and carbon naturally present in the rice hulls. U.S. Patent No. 3,754,076 describes the rice hull process and suggests that it may be preferable to assist the formation of silicon carbide from rice hulls by the addition of iron in the form of iron oxide. The SiC whiskers obtained via the rice hull process however do not appear to be of the VLS-type. They typically have a diameter of approximately 0.5 micron and lengths approaching 100 microns, but no metallic sphere is visible at the end of the straight whisker. These whiskers presumably form via a gas-solid reaction mechanism which does not involve a liquid transition metal catalyst. Whiskers formed from the rice hulls must undergo extensive purification to remove undesirable particulate by-products. The tedious purification process is described in U.S. 4.249,700, 4,256,571 and 4,293,099.

Although the prior art has recognized the catalytic effect of transition metals for producing silicon carbide whiskers and fibers, to our knowledge there has been no attempt to use microfibrous carbon, such as that obtained from the metal-catalyzed disproportionation of carbon monoxide or the decomposition of gaseous hydrocarbons, to obtain fibrous ceramic products. The present inventors have developed a unique process which uses microfibrous carbon so produced to prepare a reproducible, high yield of silicon carbide fibers and whiskers, of good size and at low cost for use in high temperature composite materials. It has been discovered that the fibrous morphology of the carbon and presence of the metal catalyst enhances the yield of fibrous ceramic products and reduces the amount of unwanted particulate by-products.

Furthermore, the flexibility of the method according to the present invention provides an economical means for producing silicon nitride whiskers and fibers. The process of the present invention allows one to use gases from low value waste streams, such as carbon monoxide produced by the carbothermic reduction reactions which themselves produce ceramics (i.e., equation 1), as the feedstock for the preparation of reinforcement materials which can be used in high value composites. Microfibrous carbon can also be obtained from the carbon monoxide in the off gas from fluid cat-cracking units or other refinery operations.

Additional advantages of the present invention shall become apparent as described below.

## SUMMARY OF THE INVENTION

It is the primary object of the present invention to form fibrous silicon carbide and silicon nitride by mixing a silicon source, preferably $SiO_2$, a $SiO_2$ precursor (i.e., silica sol, silicone or organosilanes) or Si metal, and microfibrous carbon to form a silicon-carbon mixture which is subsequently heated to a temperature of at least 1300°C in either the presence of a non-oxidizing gas or under vacuum. In particular, the present invention utilizes fibrous carbon having a transition metal, such as Fe, Co, Ni, Ru, Rh, Re, Os, Mn, Cr, V, Ti, Cu, W, Pt, Pd, Mo and Au, combined therewith. The filamentous or fibrous morphologies and crystalline phases of the microfibrous carbon influence the morphology and crystalline phase of the resulting silicon carbide product, thus enhancing the whisker and/or fiber yield, and reducing the yield of unwanted particulate by-product. The fibrous morphology of the microfibrous carbon acts as a template for deposition of Si and thus the resultant fibrous morphology of the silicon carbide. The transition metal can also have a promoting effect when heated with the silicon source to produce fibrous silicon carbide and silicon nitride.

To form silicon carbide, the silicon-carbon mixture is heated at a temperature between about 1400-2300°C, preferably 1400-1800°C, in the presence of a gas selected from the group consisting of $H_2$, $N_2$, Ar, He and mixtures thereof. In the presence of nitrogen gas, the mixture of $SiO_2$ and carbon should be heated at a temperature where the formation of SiC is thermodynamically more favorable than the formation of $Si_3N_4$, i.e., at least 1600°C to avoid the formation of silicon nitride. Likewise, if silicon metal is combined with microfibrous carbon in the presence of nitrogen gas, then it must be done so at a temperature of at least 1430°C to avoid the formation of silicon nitride.

The $SiO_2$ is to be mixed with microfibrous carbon in a carbon/silica ration of at least 3 to 1. The fibrous silicon carbide formed in accordance with the present invention is substantially of the beta-silicon carbide form. Much of the fibrous silicon carbide has the same size and morphology as the microfibrous carbon itself, i.e., a twisted, fibrous morphology with diameters typically less than 0.1 micron. This microfibrous silicon carbide is distinct from the larger, straight SiC whiskers with diameters in the 0.1-1 micron range, formed via a VLS mechanism or by the gas-solid process such as that which occurs in the rice hull process. The reaction between microfibrous carbon and $SiO_2$ can produce SiC whiskers of both the VLS and rice hull type in addition to the microfibrous SiC, and the conditions can be varied to optimize the yield of a fibrous product with a particular morphology.

Fibrous silicon nitride may also be formed by mixing either $SiO_2$ or silicon metal with microfibrous carbon and subsequently heating to a temperature of at least 1300°C in the presence of nitrogen gas. In accordance with this embodiment, it is preferable to heat the silicon-carbon mixture at a temperature in the range between 1300°-1600°C when $SiO_2$ is used as the silicon source. $SiO_2$ is generally mixed with the microfibrous carbon in a carbon/silicon ratio of at least 2.

Additionally, fibrous silicon carbide may also be formed by reacting either $SiH_4$ or $Si_2H_6$ with microfibrous carbon at a temperature of at least 300°C.

The present invention may also include many additional features which shall be further described below.

Generally, the present invention provides a method for forming fibrous silicon carbide comprising the following steps:
mixing a silicon source and microfibrous carbon, said microfibrous carbon has a diameter less than 0.1 microns and contains at least one transition metal, wherein a silicon-carbon mixture is formed; and
heating said silicon-carbon mixture in the presence of a non-oxidizing gas or in a vacuum to a temperature sufficient to convert said mixture to fibrous silicon carbide having a diameter of about 1.0 microns or less.

## DESCRIPTION OF THE PREFERRED EMBODIMENTS

The present invention provides a novel method for the formation of silicon carbide and silicon nitride whiskers suitable for use in composite materials via the reaction of $SiO_2$, Si or other silicon compounds with microfibrous carbon. It is a two step process requiring the mixing of a silicon source with microfibrous carbon and subsequently heating the silicon-carbon mixture to a temperature in the range between 1300-2300° C in the presence of a non-oxidizing gas or vacuum. It is believed that due to the morphological structure of the fibrous carbon and the presence of a transition metal in the carbon in suitable catalytic amounts, that the present invention provides an inexpensive means for producing fibrous silicon carbide in high yield. The fibrous silicon carbide and/or silicon nitride formed by this method have morphologies, similar to that of the microfibrous carbon itself, of the VLS type or of the straight type without any metal sphere.

An advantage of this invention is that microfibrous carbon is an inexpensive, readily available carbon source. Microfibrous carbon is typically formed by the deposition of carbon from carbon monoxide onto a transition metal containing catalyst, where the metal is usually iron, cobalt or nickel. The formation of microfibrous carbon is more fully disclosed in Great Britain Patent Application No. 2,002,726 which is included herein by reference. Microfibrous carbon can be produced very inexpensively, whereas high grade carbon black sells for approximately 30 cents per pound and activated carbon can be even more. Furthermore, the morphology of the microfibrous carbon is believed to influence the morphology of the resultant silicon carbide thus resulting in a higher yield of fibrous product. The microfibrous carbon can act as a template for fibrous silicon carbide formation, such that the gaseous silicon-containing species can diffuse into the graphitic-like structure of the microfibrous carbon resulting in the retention of the fibrous morphology. A combination of the microfibrous carbon and the transition metal contained therein also results in production of a silicon carbide whisker and/or fiber of satisfactory dimensions. Another advantage of the use of microfibrous carbon is that it does not require an additional step to introduce a transition metal catalyst since the microfibrous carbon already contains such a catalyst. It is important to note that the elements typically used to catalyze the formation of microfibrous carbon, particularly iron, cobalt and nickel, are also known to catalyze the formation of silicon carbide. By controlling the deposition conditions, low levels of these transition metal elements, usually less than 5 weight percent, are present in microfibrous carbon.

Microfibrous carbon may be prepared by passing a mixture of carbon monoxide and hydrogen through a tube furnace at 450-550° C over an iron powder or steel balls of a weight about 5 grams and a diameter of about one eighth of an inch. Prior to carbon deposition, the transition metal, i.e., the iron powder or steel balls, may be pre-reduced by an atmosphere which contains hydrogen. The temperature of this reduction is in the range between 300-650° C. After a few hours fibrous carbonaceous material will appear an iron powder or the steel balls. The amount of carbon deposited on the transition metal can be determined by oxidation in a thermal gravimetric analyzer.

The preferred method according to the present invention is to mix either $SiO_2$ or $Si$ (silicon metal) and microfibrous carbon to form a silicon-carbon mixture. The silicon-carbon mixture is thereafter heated in the range between 1300-2300° C, preferably above 1450° C if silicon carbide is desired. The silicon-carbon mixture is heated in either the presence of a gas, such as $H_2$, $N_2$, $Ar$, $He$ or mixtures thereof, or in a vacuum. The microfibrous carbon is a filamentous carbon, which contains less than 5 weight percent of a transition metal. The transition metal may be one selected from the group consisting of $Fe$, $Co$, $Ni$, $Ru$, $Rh$, $Re$, $Os$, $Mn$, $Cr$, $V$, $Ti$, $Cu$, $W$, $Pt$, $Pd$, $Mo$ and $Au$, preferably either iron, cobalt or nickel. It is believed that the transition metal acts as a catalyst for the formation of fibrous silicon carbide or silicon nitride.

When the atmosphere is a nitrogen-containing gas, it has been discovered that silicon carbide whiskers and fibers are formed as the predominant product when the silicon-carbon mixture is heated to a temperature of at least 1600° C in the case of $SiO_2$ and heated to a temperature of at least 1430° C when silicon metal is used. Otherwise, experiments have shown that substantial amounts of silicon nitride whiskers and/or fibers will be formed together with the silicon carbide whiskers and/or fibers.

The reaction of $SiO_2$ and carbon to produce silicon carbide has the following stoichiometric reaction:

$$SiO_2 + 3C \rightarrow SiC + 2CO \qquad (2)$$

An intimate mixture of silica and microfibrous carbon with a carbon/$SiO_2$ ratio of at least three is prepared by suitable means, i.e., ball-milling, sol-gel using a silica sol or suitable organosilane as the $SiO_2$ source, etc. Upon heating at temperatures above 1400° C, there appear to be three types of silicon carbide products which form in the carbothermic reduction step, each having different morphologies. The first is the template type, i.e., a microfibrous silicon carbide with a morphology very similar to the fibrous carbon (twisted, diameter < 0.1 micron). This type of fibrous silicon carbide is favored when the metal content of the carbon is low (< 2%), and when the C/$SiO_2$ ratio is three or greater. The high C/$SiO_2$ ratio permits the carbon to carry out the carbothermic reduction and also provides enough carbon to act as a template. This type of fibrous silicon carbide appears to be favored when the atmosphere is truly inert, i.e., Ar or He instead of $N_2$ or $H_2$.

The second morphology is the VLS-type whiskers. This type of fibrous silicon carbide clearly involves the transition metal, so it is favored when the metal content of the carbon is higher (2-5%) and the $C/SiO_2$ ratio is lower than three. The VLS whiskers have a diameter of 0.1-0.5 micron and lengths less than 10 microns; they are straight, not twisted, and the metal sphere can be observed at the tip of one end. The VLS mechanism operates in a fairly narrow temperature regime, 1400-1550° C, and appears to be enhanced when the atmosphere contains some nitrogen.

The third morphology is the rice hull-type whiskers. These are bigger whiskers, having a diameter between 0.1-1 micron and lengths approaching 100 microns. They are straight and needle like, but there is no metal sphere at one end. They appear to form by a gas phase process. The highest yields were observed when the atmosphere contained $H_2$. The formation of this type also appeared to be most favorable when the $C/SiO_2$ ratio is two and the transition metal content of the carbon is low, less than 1%.

It is preferable that the fibrous silicon carbide and/or silicon nitride formed by the present invention be further subjected to either calcination to remove undesirable carbon, washing with HF to remove silica, and/or acid leaching to remove metals.

The reaction of $SiO_2$ and microfibrous carbon to produce silicon nitride whiskers and/or fibers has the following stoichiometric reaction:

$$3SiO_2 + 6C + 2N_2 \rightarrow Si_3N_4 + 6CO \qquad (3)$$

In forming silicon nitride, an intimate mixture of silica and microfibrous carbon with a carbon/$SiO_2$ ratio of at least 2 to 1 is fired in a flowing nitrogen-containing atmosphere, i.e., $N_2$ or $NH_3$, at a temperature in a range between 1300° C to 1600° C, preferably less than or equal to 1500° C. This reaction results in the formation of silicon nitride whiskers, usually found on the surface in the form of a white mat with a substantial amount of fibrous silicon carbide present therein.

The reaction of silicon metal (Si) and microfibrous carbon to produce silicon carbide whiskers and/or fibers has the following stoichiometric reaction:

$$Si + C \rightarrow SiC \qquad (4)$$

An intimate mixture of the reactants is preferably prepared by first grinding the Si then sieving to 60 mesh, although the grinding and sieving is not necessary, then mixing the Si with the microfibrous carbon and further grinding and ball-milling. The resultant mixture is preferably fired at temperatures between 1300-2300° C; under a nitrogen atmosphere, firing temperatures where the formation of SiC is thermodynamically more favorable than silicon nitride, i.e. in excess of 1430° C, are preferable. The resultant silicon carbide whiskers typically have a diameter between 0.1 and 1 micron, and a length to diameter ratio greater than 10. The silicon carbide formed in accordance with the reaction of silicon metal and microfibrous carbon is almost exclusively the beta (cubic) form of silicon carbide.

The reaction of either $SiH_4$ or $Si_2H_6$ and microfibrous carbon to produce fibrous silicon carbide has the following stoichiometric reaction:

$$SiH_4 + C \rightarrow SiC + 2H_2 \qquad (5)$$

The $SiH_4$ or $Si_2H_6$ is intimately contacted with the microfibrous carbon by suitable means. The reactants are heated at temperatures above 300° C such that the silane decomposes to liberate hydrogen gas such that the silicon can react with the carbon to form fibrous silicon carbide. In accordance with this embodiment of the present invention the temperature range must be between 300-2300° C.

Example 1

A fibrous mixture of silicon carbide and silicon nitride was prepared from the reaction of silica ($SiO_2$) and microfibrous carbon, prepared by the iron catalyzed disproportionation of carbon monoxide in the presence of $H_2$ at 450° C. Prior to carbon deposition, the iron powder was pre-reduced by an atmosphere which contained hydrogen. The temperature of this reduction is in the range between 300-650° C. The iron was preheated by placing it in a quartz tube and heating in a furnace at 550° C for 1 1/2 hours with a 1 to 1 mixture of $H_2/Ar$ gas flowing upward through the tube at 300 cc/min. With the same gas flow, the temperature was raised to 650° C for an additional hour. Thereafter the tube was cooled to approximately 450° C at which point the gas flow as changed to a mixture of 4 to 1 $CO/H_2$ at 333 cc/min., where it was allowed to react for 3 hours. The amount of carbon deposited on the iron can be determined by oxidation in a thermal gravimetric analyzer. The iron content of the carbon was 1.4% by weight. 5 grams of F-5 silica (surface area greater than 600 m $^2$/gms) from Akzo Chemie America, and 3 grams of microfibrous, iron-containing carbon were combined and ball-milled for six hours. 3.8 grams of the silica-carbon mixture were heated to a temperature of 1450°C under a $N_2$ flow of approximately 1000 cc/min and held for 5 hours. The product was spongy in texture, light green in color at the surface and darker gray in the bulk; the final weight being 1.82 grams. X-ray analysis indicated that the product consisted primarily of crystalline beta-SiC with a lesser amount of alpha and beta $Si_3N_4$. Microscopic analysis revealed that much of the product had a fibrous morphology similar to the starting carbon; some whiskers with a metallic sphere attached to one end were observed. Thus it can be seen that the microfibrous carbon acted as a template for the formation of microfibrous silicon carbide and that the presence of the iron in the microfibrous carbon also resulted in the formation of a whisker product.

Example 2

A comparison experiment reacting silica (F-5 silica) and activated carbon was run, wherein 5 grams of F-5 silica and 3 grams of activated charcoal powder from Mallinckrodt (No. 4394) were ball-milled overnight, and 3.39 grams of the silica-carbon mixture were heated to 1450°C under flowing nitrogen gas and held for 5 hours. The final product had the spongy texture of Example 1 and weighed 1.71 grams, but X-ray analysis revealed that the sample was predominantly silicon nitride, not silicon carbide, and that the product was much more particulate in nature than in the microfibrous carbon experiment of example 1 which resulted in the formation of whiskers and fibers, of both the template and VLS-type. The use of the microfibrous carbon containing iron in Example 1 also enhanced the formation of silicon carbide relative to silicon nitride.

Example 3

Additional experiments were conducted using microfibrous carbon as prepared above to determine how the reaction temperature affected the relative yields of silicon carbide and silicon nitride. 3:1 mixtures of carbon to $SiO_2$ were fired individually at reaction temperatures of 1400, 1500, 1600 and 1700°C under a nitrogen flow of 800 cc/min. All the products from those reactions looked essentially the same to the eye, a grayish green slightly spongy powder. It was observed by x-ray diffraction that the higher the reaction temperature, the greater the yield of silicon carbide relative to silicon nitride. It was also observed by microscopic examination that the yield of VLS-type whiskers with a metallic sphere at one end was highest in the experiments run at temperatures of 1400-1500°C. In the experiments run at 1500°C, a white-outer layer of silicon nitride whiskers formed on the product.

Example 4

1.6437g of a ball-milled mixture of a 2:1 microfibrous carbon/silica mixture was placed in a graphite boat and covered with a graphite sheet. The microfibrous carbon contained 0.98% Fe by weight. The sample was heated in a tube furnace under a $H_2$ flow of 200cc/min. The temperature was ramped at 20°C/min to 1000°C and then at 5°C/min from 1000-1450°C where it was held for 5 hrs. After the reaction the sample weighed 0.5012g, a 69.51% weight loss. X-ray diffraction indicated the product was beta silicon carbide. After removing unreacted $SiO_2$ and carbon, microscopic examination of the product showed a large number of needle-like whiskers approximately 50-100 micrometers in length and 0.5 micrometers in diameter with no metallic spheres visible at the tip. The whiskers were interspersed amongst an SiC product that had the same twisted microfibrous morphology as the starting carbon source.

Example 5

A stoichiometric mixture of silicon metal (Si) and microfibrous carbon was prepared. Fischer Scientific fused silicon metal was ground and sieved to greater than 60 mesh. The microfibrous carbon was also sieved to greater than 60 mesh before using. The mixture was further ground by hand with a mortar and pestal before firing. The mixture was fired at roughly 1720°C in a flowing $N_2$ atmosphere in an open crucible. The nitrogen flow rate was 5 liters/min. The heat-up to 1720°C was over roughly 1 hour. The reactants were heated at 1720°C for 15 minutes then cooled to 100°C over an 80 minute period. The resultant product was a coarse green powder. Gravimetric analysis for carbon by oxidation in air at 800°C showed residual carbon to be present at 1.6 weight percent. X-ray analysis indicated virtually 100 percent silicon carbide yield. Analysis by scanning electron microscopy revealed many whiskers having a diameter of 0.1-1 micron.

Example 6

Samples of silicon metal and microfibrous carbon were prepared and reacted at 1700°C in either pure $H_2$, CO or Ar atmospheres. An X-ray analysis showed the primary product phase to be beta-silicon carbide. Of the three samples, the sample run in a hydrogen atmosphere resulted in the highest yield of whiskers, followed by that run in the Ar atmosphere. These whiskers have a more uniform morphology and are more numerous than the samples formed under nitrogen gas in Example 5. No whiskers were found in the sample run in the carbon monoxide atmosphere.

The above examples indicate that by varying the reaction conditions (i.e., temperature, atmosphere, $C/SiO_2$ ratio, metal content in the carbon, etc.) the composition (SiC vs. $Si_3N_4$) and fibrous morphology of the product can be controlled to give a product or mixture of products suitable for use as a high temperature reinforcement material for composites.

While we have shown and described several embodiments in accordance with our invention, it is to be clearly understood that the same are susceptible to numerous changes and modifications apparent to one skilled in the art. Therefore, we do not wish to be limited to the details shown and described but intend to show all changes and modifications which come within the scope of the appended claims.

## Claims

1. A method for forming fibrous silicon carbide comprising the following steps:
mixing a silicon source and microfibrous carbon, said microfibrous carbon has a diameter less than 0.1 microns and contains at least one transition metal, wherein a silicon-carbon mixture is formed; and
heating said silicon-carbon mixture in the presence of a non-oxidizing gas or in a vacuum to a temperature sufficient to convert said mixture to fibrous silicon carbide having a diameter of about 1.0 microns or less.

2. The method according to claim 1, wherein said temperature is in the range between about 1300-2300°C.

3. The method according to claims 1 or 2, wherein said silicon source is at least one selected from the group consisting of: $SiO_2$, Si, a silica sol, silicone and organosilanes.

4. The method according to any of the preceding claims, wherein said transition metal is selected from the group consisting of Fe, Co, Ni, Ru, Rh, Re, Os, Mn, Cr, V, Ti, Cu, W, Pt, Pd, Mo and Au.

5. The method according to any of the preceding claims, wherein said transition metal is present in an amount less than 5 weight percent of said microfibrous carbon.

6. The method according to any of the preceding claims, wherein said gas is selected from the group consisting $H_2$, Ar, He, $N_2$ or mixtures thereof.

7. The method according to any of the preceding claims, wherein said gas is $N_2$, said silicon-carbon mixture is heated at a temperature in the range of about 1300-1700°C and wherein fibrous silicon nitride having a diameter of about 1.0 microns or less is formed together with said fibrous silicon carbide.

8. The method according to any of the preceding claims, wherein said silicon-carbon mixture is heated at a temperature of at least 1600°C, said silicon source is $SiO_2$ and said gas is $N_2$.

9. The method according to any of claims 1 through 6, wherein said silicon source is $SiO_2$ and wherein said microfibrous carbon and $SiO_2$ are mixed in a carbon/silicon ratio greater than 1.

10. The method according to any of claims 1 through 6, wherein said silicon source is $SiO_2$, said silicon-carbon mixture has a carbon/$SiO_2$ ratio of at least 1, and said microfibrous carbon has a transition metal content of less than 5 weight percent; whereby a fibrous silicon carbide of the template-type having a twisted, fibrous morphology with a diameter less than 0.1 microns, the VLS-type having a straight, fibrous morphology with a diameter in the range between about 0.1-0.5 microns and a metal sphere attached thereto, and the rice hull-type having a straight, fibrous morphology with a diameter in the range between 0.1-1.0 microns are formed.

11. The method according to any of claims 1 through 6, wherein silicon source is $SiO_2$, said silicon-carbon mixture has a carbon/$SiO_2$ ratio of at least 3, and said microfibrous carbon has a transition metal content of less than 2 weight percent; whereby fibrous silicon carbide of the template-type, having a twisted, fibrous morphology with a diameter less than 0.1 microns, is formed.

12. The method according to any of claims 1 through 6, wherein said silicon source is $SiO_2$, said silicon-carbon mixture has a carbon/$SiO_2$ ratio of at least 1, said microfibrous carbon has a transition metal content of less than 5 weight percent, and the heating temperature is in the range between about 1400-1800°C; whereby fibrous silicon carbide of the VLS-type, having a straight, fibrous morphology with a diameter in the range between 0.1-0.5 microns and a metal sphere attached thereto, is formed.

13. The method according to any of claims 1 through 6, wherein said silicon source is $SiO_2$, said silicon-carbon mixture has a carbon/$SiO_2$ ratio of at least 2, said microfibrous carbon has a transition metal content of less than 1 weight percent, the heating temperature is in the range between about 1400-1800°C, and said non-oxidizing gas contains H₂; whereby fibrous silicon carbide of the rice hull-type, having a straight, fibrous morphology with a diameter in the range between 0.1-1.0 microns, is formed.

14. The method according to any of claims 1 through 6, wherein said silicon source is Si, said gas is N₂, and said silicon-carbide mixture is heated at a temperature of at least 1430° C.

15. The method according to any of claims 1 through 6, wherein said silicon source is Si and wherein said microfibrous carbon and Si are mixed in a carbon/silicon ratio of at least 1.

16. The method according to any of the preceding claims, wherein said silicon source and said microfibrous carbon are mixed by ball-milling.

17. The method according to any of the preceding claims, wherein said silicon source and said microfibrous carbon are mixed by sol-gel.

18. A method according to claims 1 or 4, wherein said silicon source is SiH₄ and/or Si₂H₆, and said silicon-carbon mixture is heated at a temperature in the range between about 300° C-2300° C.

19. The method according to any of the preceding claims, wherein said microfibrous carbon is formed by passing carbon monoxide and hydrogen over a transition metal at a temperature in the range between about 450-550° C.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 284 612  (HORNE, Jr. et al.)<br>* Column 2, lines 26-59; column 3, lines 10-33 *<br>--- | 1-4,6,7 | C 30 B   29/62<br>D 01 F    9/08<br>C 01 B   31/36 |
| A | PATENT ABSTRACTS OF JAPAN, vol. 8, no. 71 (C-217)[1508], 3rd April 1984; & JP-A-58 223 696 (ASAHI KASEI KOGYO K.K.) 26-12-1983<br>* Abstract *<br>--- | 1-3,6-8 | |
| A | PATENT ABSTRACTS OF JAPAN, vol. 9, no. 287 (G-314)[2010], 14th November 1985; & JP-A-60 131 895 (NIPPON DENSO K.K.) 13-07-1985<br>--- | | |
| A | FR-A-2 522 024  (TOKAI CARBON CO., LTD) & US-A-45 00 504 (Cat. D)<br>--- | | |
| A | EP-A-0 174 622  (NIKKISO CO., LTD)<br>--- | | |
| A,D | US-A-3 840 647  (CHUJI TOMITA et al.)<br>----- | | |

TECHNICAL FIELDS
SEARCHED (Int. Cl.4)

C 01 B
C 30 B
D 01 F

The present search report has been drawn up for all claims

| Place of search | Date of completion of the search | Examiner |
|---|---|---|
| THE HAGUE | 09-01-1989 | COOK S.D. |